(19) Europäisches Patentamt

European Patent Office

Office européen des brevets

(11) EP 0 676 769 B1

(12) **FASCICULE DE BREVET EUROPEEN**

(45) Date de publication et mention de la délivrance du brevet:
**21.08.1996 Bulletin 1996/34**

(51) Int Cl.$^6$: **G11C 29/00**, G06F 12/00

(21) Numéro de dépôt: **95460015.1**

(22) Date de dépôt: **03.04.1995**

(54) **Mémoire non volatile modifiable électriquement incorporant des fonctions de test**

Elektrisch veränderlicher Festspeicher mit Prüffunktionen

Electrically alterable read only memory comprising test functions

(84) Etats contractants désignés:
**DE FR GB IT**

(30) Priorité: **08.04.1994 FR 9404565**

(43) Date de publication de la demande:
**11.10.1995 Bulletin 1995/41**

(73) Titulaire: **SGS-THOMSON MICROELECTRONICS S.A.**
**F-94250 Gentilly (FR)**

(72) Inventeur: **Gaultier, Jean-Marie, Bernard**
**F-56100 Lorient (FR)**

(74) Mandataire: **Dubreuil, Annie**
**Cabinet Ballot-Schmit,**
**4, rue Général Hoche**
**56100 Lorient (FR)**

(56) Documents cités:
**EP-A- 0 548 866**　　　　**US-A- 4 024 386**

## Description

L'invention se situe principalement dans le domaine des mémoires intégrées non volatiles modifiables électriquement et concerne plus particulièrement les mémoires de type "FLASH EEPROM".

Les procédés de fabrication des circuits intégrés introduisent très souvent des défauts. Aussi, après fabrication, chaque circuit intégré est soumis à des tests visant à déceler la présence de tels défauts. Ainsi, dans le cas des mémoires non volatiles ayant normalement après fabrication toutes leurs cellules mémoire effacées, on vérifie d'abord la virginité du plan mémoire en effectuant une lecture systématique pour toutes les adresses de façon à s'assurer que chaque cellule mémoire est bien effacée. On envoie ensuite des commandes d'écriture à des adresses déterminées de façon à programmer les cellules correspondantes puis on relit la mémoire pour ces mêmes adresses, toute divergence entre les données qui auraient dû être écrites et les données lues indiquant l'existence d'un défaut.

Pour les mémoires de capacité importante, il est essentiel de réduire le temps de test nécessaire à la détection des défauts et donc d'organiser de façon optimale le test exhaustif du produit, c'est-à-dire portant sur toutes les configurations possibles des états programmés ou effacés de tout l'espace mémoire. Les mémoires étant en général organisées en matrice formée de rangées et de colonnes de cellules, il est possible de limiter le nombre de configurations à prévoir tout en ayant une information significative sur l'intégrité de la mémoire après chaque étape du test.

Ainsi, l'adresse d'une cellule (ou d'un ensemble de cellules formant un mot) étant formée d'une adresse de rangée et d'une adresse de colonne correspondant respectivement aux poids faibles et aux poids forts de l'adresse, on peut par exemple vérifier le bon fonctionnement des décodeurs de rangées en programmant successivement toutes les cellules de la première rangée. Pour cela, on provoque la programmation des cellules dont les adresses ont leurs poids forts à zéro. On effectue ensuite la relecture pour ces mêmes adresses et on vérifie que les données lues correspondent bien à des cellules programmées. De même, on peut vérifier les décodeurs de colonnes en programmant successivement les cellules dont les adresses ont leurs poids faibles à zéro. On peut également vérifier l'absence d'interactions entre les décodeurs de rangées et de colonnes en programmant la diagonale de la matrice. Enfin, pour détecter les interaction possibles entre les cellules, on programme par exemple toutes les cellules dont les adresses ont des poids forts et des poids faibles de même parité de façon à constituer des damiers de cellules programmées. On termine en programmant les cellules selon un damier complémentaire.

Ces quelques tests simples constituent une première étape permettant de détecter rapidement des défauts fréquents.

Jusqu'à présent, les opérations de test telles que celles qui viennent d'être décrites sont effectuées au moyen d'un testeur relié aux bornes externes du circuit intégré à tester. Le testeur est une unité programmée pour générer automatiquement les adresses et les données correspondant aux profils de test à effectuer et pour appliquer les commandes correspondantes sur les bornes du circuit. Le testeur commande ensuite la lecture de la mémoire pour les mêmes adresses et compare les données lues aux données écrites.

Cette méthode implique donc une opération complète d'écriture pour chaque cellule (ou chaque mot) à programmer. Il en résulte que le temps nécessaire pour effectuer le test complet de chaque mémoire est relativement long surtout s'il s'agit d'une mémoire de grande capacité et si le protocole de communication nécessite plusieurs cycles pour chaque commande d'écriture.

Aussi, l'invention a pour but de réduire le temps de test en remplaçant les commandes d'écriture externes par des mécanismes automatiques de programmation interne.

Dans ce but, l'invention a pour objet une mémoire non volatile modifiable électriquement par des opérations d'effacement et de programmation, ladite mémoire comportant :

- au moins une matrice de cellules mémoire organisées en rangées et en colonnes,

- des moyens d'alimentation pour appliquer des tensions d'effacement et de programmation auxdites rangées et colonnes, lesdites tensions de programmation étant appliquées sélectivement aux rangées et colonnes identifiées respectivement par des adresses de rangée et des adresses de colonne,

- un générateur d'adresse comportant des moyens de comptage commandés par un signal d'incrémentation,

- des moyens de commande desdits moyens d'alimentation et dudit générateur d'adresse,

ladite opération d'effacement consistant en l'exécution par lesdits moyens de commande d'un premier algorithme de programmation avant effacement suivi d'un second algorithme d'effacement, ledit premier algorithme consistant à commander l'incrémentation desdits moyens de comptage pour qu'il fournisse successivement toutes les valeurs possibles desdites adresses de rangée et de colonne et, pour chaque valeur d'adresse fournie, à commander lesdits moyens d'alimentation pour qu'ils fournissent lesdites tensions de programmation, ladite mémoire étant caractérisée en ce que lesdits moyens de comptage comportent un compteur de rangée et un compteur de colonne fournissant respectivement lesdites valeurs d'adresse de rangée et de colonne, en ce que ledit générateur d'adresse est prévu pour fonctionner selon un mode normal et au moins un mode de test, le fonctionnement en mode(s) de test étant conditionné par un premier mot de test, ledit mode normal consistant à incrémenter ledit compteur de rangée exclusivement par ledit signal d'incrémentation et ledit compteur de colonne exclusivement par un signal de dépassement dudit compteur de rangée, le(s)dit(s) mode(s) de test consistant à autoriser l'incrémentation par ledit signal d'incrémentation dudit compteur de rangée et/ou l'incrémentation dudit compteur de colonne en fonction dudit premier mot de test.

Etant donné que la mise en oeuvre des modes de test utilise en grande partie des moyens nécessaires en fonctionnement normal (algorithme de programmation avant effacement, moyens de comptage), l'invention présente en outre l'avantage d'un surcoût très faible.

Conformément à l'invention, on pourra prévoir un premier mode de test pour programmer la première rangée en incrémentant uniquement le compteur de rangée ou bien un second mode de test pour programmer la première colonne en incrémentant uniquement le compteur de colonne ou bien un troisième mode de test pour programmer la diagonale en incrémentant simultanément les compteurs de rangée et de colonne.

Certaines mémoires comportent plusieurs matrices de cellules mémoire définissant chacune un secteur sélectionnable par une adresse de secteur. Ces mémoires sont généralement prévues pour qu'on puisse effacer sélectivement l'un quelconque des secteurs ou la totalité de ces derniers (effacement global). Les moyens de comptage peuvent alors être décomposés en un compteur de rangée, un compteur de colonne et un compteur de secteur, ce dernier compteur étant prévu pour effectuer l'effacement global de la mémoire. Aussi, selon un autre mode de réalisation de l'invention, un quatrième mode de test consiste à incrémenter simultanément lesdits compteurs de rangée et de colonne par ledit signal d'incrémentation et à commander l'incrémentation dudit compteur de secteur par un signal de dépassement dudit compteur de colonne.

Afin de détecter les interactions entre plusieurs secteurs, on prévoira avantageusement que le signal de dépassement dudit compteur de colonne commande l'incrémentation dudit compteur de colonne lorsque le générateur d'adresse fonctionne selon ledit quatrième mode de test. Cette dernière disposition permet en effet de décaler les diagonales de cellules programmées lorsque l'on passe d'un secteur au suivant.

Pour pouvoir effectuer d'autres tests produisant des alternances de cellules programmées et non programmées de chaque matrice, l'invention prévoit en outre que les moyens de commande comportent au moins un générateur de donnée pouvant être placé dans un premier ou un second état et qui, lors de l'exécution dudit premier algorithme, commande lesdits moyens d'alimentation pour qu'ils appliquent lesdites tensions de programmation à condition que ledit générateur de donnée soit dans ledit premier état, ledit générateur de donnée étant prévu pour fonctionner selon un mode normal ou au moins un mode de test, le fonctionnement en mode de test étant conditionné par un second mot de test, ledit fonctionnement en mode normal consistant à placer ledit générateur de donnée dans ledit premier état, le fonctionnement en mode de test consistant à placer ledit générateur de donnée dans ledit second état en fonction dudit second mot de test et des adresses fournies par ledit générateur d'adresse.

La présence du générateur de donnée qui vient d'être défini permet en particulier de réaliser des modes de test du type damier. Pour cela, il suffit de faire fonctionner le générateur d'adresse selon son mode normal et de placer le générateur de donnée dans son premier état en fonction des parités respectives des valeurs contenues dans les compteurs de rangée et de colonne. On obtiendra ainsi un damier pair ou impair selon que la condition imposée est que les valeurs d'adresse de rangée et de colonne ont la même parité ou ont des parités opposées.

L'invention a également pour objet un circuit intégré incorporant une mémoire ayant les caractéristiques qui viennent d'être exposées. Avantageusement, le circuit intégré contiendra également un circuit de test pour fournir les mots de test en réponse à des commandes de test extérieures au circuit intégré.

D'autres aspects et avantages de l'invention apparaîtront dans la suite de la description en référence aux figures.

- La figure 1 est un schéma d'ensemble d'une mémoire selon l'invention.

- La figure 2 représente un mode de réalisation du générateur d'adresse.

- La figure 3 représente le générateur de donnée en relation avec les circuits de lecture et d'écriture des cellules.

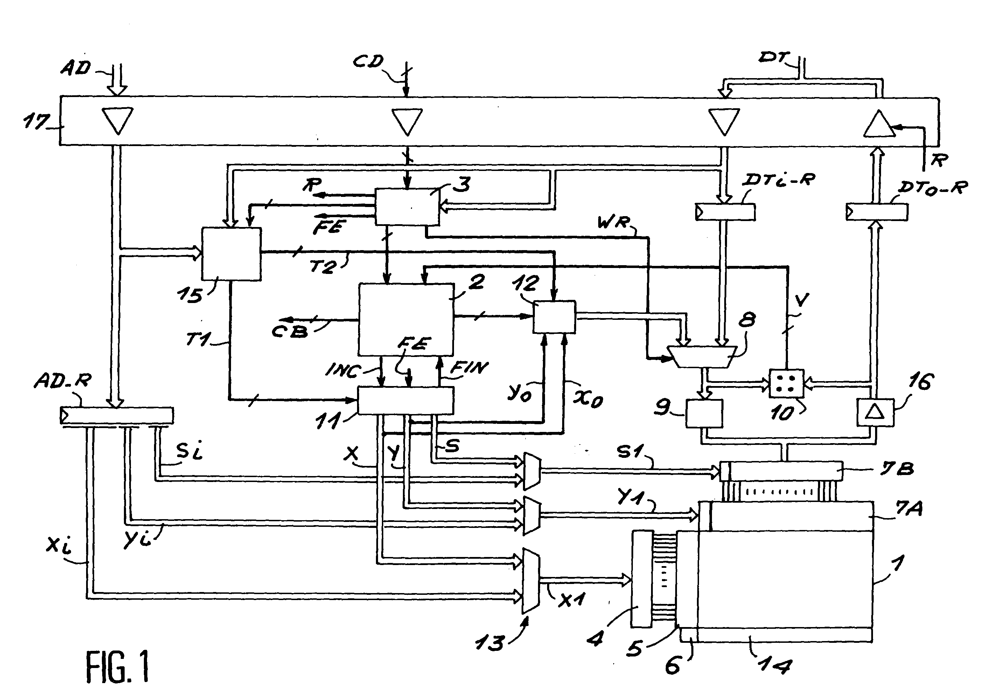

La figure 1 représente les principaux éléments constitutifs d'une mémoire selon l'invention. A titre d'exemple non limitatif, la mémoire représentée est de type "FLASH EEPROM".

La mémoire est essentiellement constituée d'une matrice 1 de cellules mémoires organisées en rangées et en colonnes, de moyens de commande 2, 3, de moyens d'alimentation 6, 9, 14 des rangées et des colonnes et de moyens de lecture 16. Chaque cellule (ou mot) de la matrice est accédée en fonction d'une adresse courante composée d'une adresse de rangée X1, d'une adresse de colonne Y1 et éventuellement d'une adresse de secteur S1 dans le cas où la mémoire est formée de plusieurs matrices indépendantes. La sélection des rangées s'effectue au moyen d'un décodeur de rangées 4 commandant un circuit de sélection 5. De même, les colonnes sont sélectionnées au moyen de décodeurs et de circuits de sélection des colonnes 7A, 7B en fonction respectivement de l'adresse de colonne Y1 et de l'adresse de secteur S1. Les adresses X1, Y1, S1 proviennent soit d'un registre d'adresse AD-R, soit d'un générateur d'adresse 11 par l'intermédiaire de sélecteurs d'adresses 13.

La mémoire communique avec les lignes externes d'adresse AD, de commande CD et de donnée DT par l'intermédiaire d'un circuit d'interface 17. Les données échangées avec l'extérieur par les lignes DT transitent par l'intermédiaire d'un registre de donnée d'entrée DTi-R pour l'écriture et d'un registre de donnée de sortie DTo-R pour la lecture. Un circuit de commande 3 reçoit des signaux externes de commande et de donnée respectivement des lignes CD et DT. Le circuit 3 a pour fonction d'interpréter ces signaux externes en vue de fournir des commandes internes telles que R, FE, WR qui conditionnent le fonctionnement de l'ensemble des circuits. En particulier, le circuit 3 coopère avec une unité de commande microprogrammée 2 qui est essentiellement chargée de contrôler les opérations de programmation et d'effacement. L'unité 2 est par exemple réalisée au moyen de réseaux logiques programmables (PLA) prévus pour exécuter des algorithmes de programmation et d'effacement qui seront expliqués plus en détail dans la suite de la description.

L'unité 2 commande un générateur de donnée 12 dont la sortie est reliée à une première entrée d'un sélecteur de données 8 dont la seconde entrée est reliée à la sortie du registre de donnée d'entrée DTi-R. La sortie du sélecteur 8 est reliée au circuit d'alimentation des colonnes 9 ainsi qu'à une première entrée d'un comparateur 10 dont la seconde entrée est reliée à la sortie des moyens de lecture 16. Le comparateur 10 fournit à l'unité 2 des signaux de comparaison V.

Un circuit de test 15 commandé par le circuit 3 reçoit les signaux de données et d'adresses externes pour fournir en particulier les mots de test T1, T2 appliqués respectivement au générateur d'adresse 11 et au générateur de donnée 12.

La mémoire est également munie de circuits d'horloge pour synchroniser le fonctionnement des différents éléments, de circuits auxiliaires d'alimentation ainsi que de circuits de reconfiguration permettant d'utiliser des cellules redondantes. Ces éléments ne sont pas représentés sur la figure de façon à ne pas la surcharger inutilement.

Avant de décrire le fonctionnement du circuit de la figure 1, il convient de rappeler les particularités des mémoires "FLASH EEPROM". Ce type de mémoire utilise comme cellule mémoire un transistor MOS particulier à grille flottante dont le seuil de conduction est modifiable par l'application sur ses électrodes de tensions appropriées. La programmation d'une cellule consiste à créer un seuil élevé (par exemple 6 volts) par l'application de tensions de programmation sur la grille (par exemple 12 volts) et sur le drain (par exemple 6 volts), la source étant à la masse. Cette programmation est sélective et contrôlée pour chaque transistor de la mémoire. Par convention, on dira qu'une cellule programmée mémorise la valeur 0 logique. L'effacement d'une cellule consiste à créer un seuil bas (par exemple 2 volts) par l'application d'une tension d'effacement (par exemple 10 volts) sur la source du transistor, sa grille étant à la masse et son drain placé à l'état de haute impédance. Contrairement à la programmation, une opération d'effacement est globale, ce qui signifie qu'elle s'applique à la totalité des cellules de la mémoire ou d'un secteur entier si la mémoire est organisée en plusieurs secteurs indépendants. Avec la convention précédente, une cellule effacée mémorise la valeur 1 logique. La lecture d'une cellule consiste à détecter son état de conduction. Pour cela, on applique sur sa grille une tension de lecture (par exemple 5 volts) et on compare le courant circulant dans la cellule à celui circulant dans une cellule de référence.

Lorsqu'on veut effectuer une opération d'écriture, c'est-à-dire modifier la programmation de certaines cellules de la mémoire, il faut au préalable effectuer l'effacement du secteur concerné. Toutefois, du fait de la nature globale de l'effacement, il est nécessaire auparavant de procéder à une programmation contrôlée de chaque cellule du secteur considéré de façon à limiter les dérives et dispersions des valeurs de seuil après l'effacement global. Cette programmation avant effacement est réalisée par l'exécution d'un algorithme spécifique qui commande l'adressage et contrôle la programmation de chacune des cellules du secteur.

En mode de fonctionnement normal, la mémoire est prévue pour effectuer essentiellement des opérations de lecture, d'effacement par secteur, d'effacement global et d'écriture. Ces opérations sont activées en fonction des signaux de commande externes et éventuellement en fonction de données externes associées. La mémoire est d'autre part prévue pour fonctionner selon un ou plusieurs mode(s) de test déterminé(s) également par les signaux externes présents sur les lignes CD et DT. Tous ces signaux externes sont reçus et interprétés par le circuit de commande 3 fournissant les divers signaux de commande correspondant aux différents éléments impliqués par l'opération à effectuer.

Ainsi, pour une opération de lecture, l'adresse reçue par les lignes AD est transmise aux entrées des décodeurs 4, 7A, 7B par l'intermédiaire du registre d'adresse AD-R et des sélecteurs d'adresses 13. Le circuit 3 active par ailleurs le circuit d'alimentation des rangées 6 et les moyens de lecture 16. Le circuit 6 applique ainsi une tension de lecture sur les grilles des cellules de la rangée sélectionnée en fonction de l'adresse X1. Les moyens 16 ont pour fonction d'alimenter les drains des cellules sélectionnées par les adresses de rangée Y1 et de comparer les courants ainsi produits à celui circulant dans une cellule de référence. Le résultat de ces comparaisons est chargé dans le registre DTo-R.

Pour une opération d'écriture, l'adresse est chargée dans le registre AD-R et la donnée à écrire est chargée dans le registre DTi-R. Le sélecteur de données 8 est positionné pour que le registre DTi-R commande le circuit d'alimentation des colonnes 9 de façon à appliquer en fonction de la donnée à écrire une tension de programmation sur les drains des cellules sélectionnées par l'adresse Y1. Parallèlement, l'unité 2 active le circuit d'alimentation 6 de façon à appliquer une impulsion de programmation calibrée sur les grilles des transistors de la rangée sélectionnée en fonction de l'adresse X1. Une lecture est ensuite effectuée pour comparer l'état de conduction des cellules à programmer à une cellule programmée de référence. Les divergences sont signalées à l'unité 2 par le comparateur 10 au moyen des signaux de comparaison V. En cas de divergence, l'unité 2 commande à nouveau une impulsion de programmation sur les grilles. Une nouvelle lecture et une nouvelle comparaison sont alors effectuées pour déterminer si une nouvelle impulsion de programmation est nécessaire. Ce cycle se répète aussi longtemps qu'une différence est détectée.

Une opération d'effacement de la mémoire s'effectue par l'exécution de deux algorithmes successifs : un algorithme de programmation avant effacement et un algorithme d'effacement proprement dit. Le sélecteur de données 8 est positionné pour permettre au générateur de donnée 12 de commander le circuit d'alimentation des colonnes 9. Pour exécuter l'algorithme de programmation avant effacement, l'unité 2 commande le générateur de donnée 12 pour qu'il fournisse en sortie la valeur zéro logique correspondant à l'état programmé des cellules. Dans le cas d'une opération d'effacement global de la mémoire, les sélecteurs d'adresses 13 sont positionnés pour transmettre les adresses internes X, Y, S du générateur d'adresse 11 aux entrées des décodeurs de rangées 4 et de colonnes 7A, 7B. L'unité 3 déclenche alors un cycle de programmation qui commande d'abord le circuit d'alimentation 6 pour fournir une impulsion de programmation sur les grilles. Puis, comme pour l'écriture, les données sont lues et comparées pour déterminer si une nouvelle impulsion de programmation est nécessaire. Dans l'affirmative, un nouveau cycle de programmation est effectué. Les cycles de programmation se répètent ainsi jusqu'à ce que le comparateur 10 ne détecte plus de différence. L'unité 2 fournit alors au générateur d'adresse 11 initialement à zéro un signal de commande d'incrémentation INC de façon à augmenter d'une unité l'adresse interne X, Y, S. L'unité 2 commande alors de nouveaux cycles de programmation de la façon indiquée précédemment. A la fin de ces cycles, l'adresse interne est à nouveau incrémentée. L'opération se répète ainsi jusqu'à ce que le générateur d'adresse détecte un dépassement d'adresse signalé à l'unité 2 par un signal de fin de comptage FIN.

L'algorithme de programmation avant effacement pour une opération d'effacement d'un seul secteur de la mémoire s'exécute de façon identique, à la différence près que seuls les poids faibles X et Y de l'adresse interne sont utilisés pour adresser la mémoire et pour détecter le dépassement d'adresse.

L'unité 2 se branche alors sur l'algorithme d'effacement qui consiste d'abord à commander le générateur de donnée 12 pour qu'il fournisse en sortie la valeur 1 logique correspondant à l'état effacé des cellules. Il commande ensuite le circuit d'alimentation des sources 14 pour qu'il applique une tension d'effacement. L'algorithme se poursuit par une succession de lecture et de comparaison visant à comparer l'état de conduction des cellules à effacer à une cellule effacée de référence. En cas de différence, la tension d'effacement est à nouveau appliquée sur les sources et une nouvelle vérification systématique de toutes les cellules est à nouveau effectuée. Ce cycle se répète aussi longtemps qu'une différence est détectée par le comparateur 10.

Comme nous l'avons déjà signalé, une opération d'effacement peut concerner un secteur particulier ou l'ensemble des secteurs de la mémoire. Dans le premier cas, le signal FIN du générateur d'adresse correspond à l'état de dépassement de l'adresse de rangée Y. Dans le second cas, il s'agit du dépassement de l'adresse de secteur S.

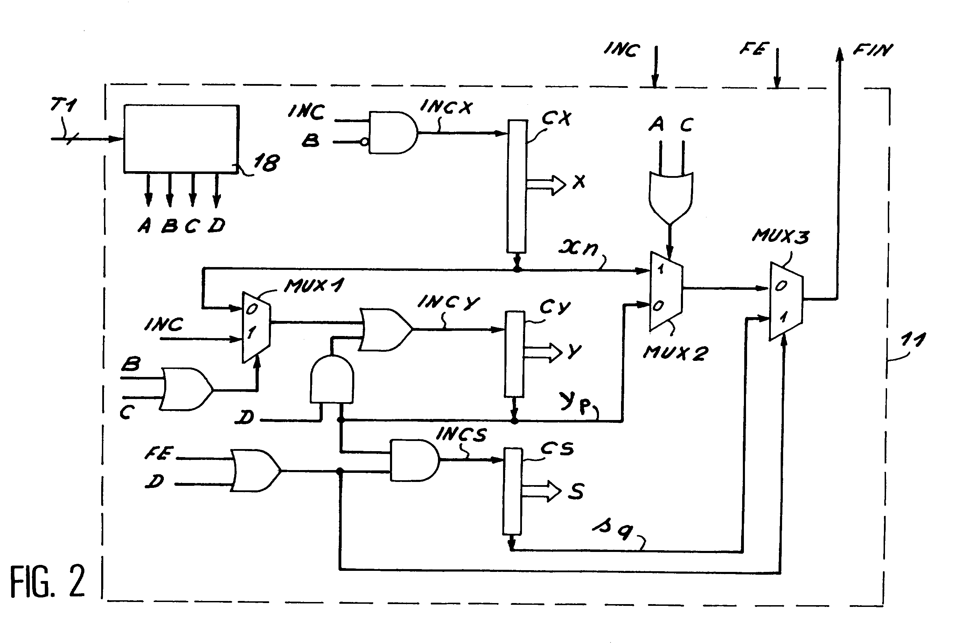

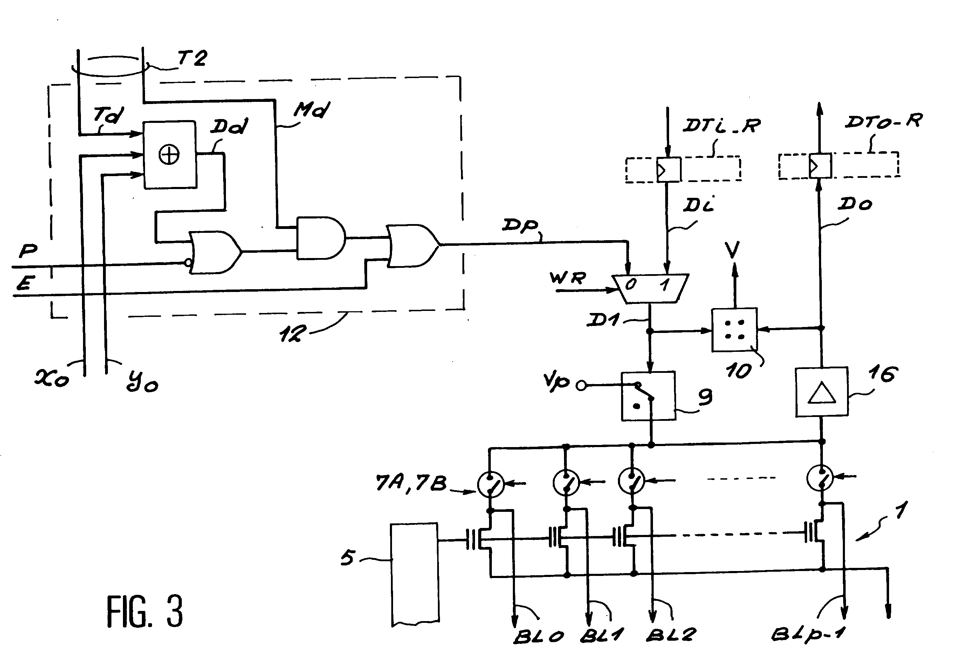

Le fonctionnement de la mémoire en mode de test est conditionné par la réception de commandes externes spécifiques détectées par le circuit de commande 3 et traitées par le circuit de test 15. En fonction de la commande reçue, donc du type de test à effectuer, le circuit 15 fournit des mots de test T1 et T2 appliqués respectivement au générateur d'adresse 11 et au générateur de donnée 12. Ces mots de test T1, T2 ont pour effet de modifier le fonctionnement des générateurs 11 et 12. L'exécution d'une opération de test consiste alors simplement à faire exécuter par l'unité 2 son algorithme de programmation avant effacement. Des détails concernant les modifications apportées aux générateurs 11 et 12 vont maintenant être données en référence aux figures 2 et 3.

La figure 2 représente un mode de réalisation d'un générateur d'adresse 11 permettant de réaliser plusieurs types de test. Selon l'exemple décrit, le premier mot de test T1 est formé de deux bits permettant de définir quatre modes de test différents. Le mot T1 est reçu par un décodeur 18 fournissant en sortie quatre signaux de modes de test A, B, C, D correspondant respectivement à la programmation de la première colonne, de la première rangée, de la diagonale d'un seul secteur et de la diagonale de tous les secteurs avec décalage d'un secteur à l'autre.

Le générateur comporte par ailleurs des compteurs de rangée CX, de colonne CY, et de secteur CS fournissant respectivement les adresses internes de rangée X, de colonne Y et de secteur S. Les adresses X, Y, S sont formées respectivement de n, p, s bits, xn, yp, sq désignant respectivement les signaux de dépassement des compteurs correspondants. Dans l'exemple présenté, on a supposé n supérieur à p.

Le générateur reçoit de l'unité 2 le signal d'incrémentation INC et du circuit de commande 3 le signal FE de commande d'effacement global de la mémoire. Les compteurs CX, CY, CS reçoivent respectivement des commandes d'incrémentation INCX, INCY, INCS fournies par un ensemble de circuits logiques commandés par les signaux INC, A, B, C, D ainsi que les signaux de dépassement xn et yp des compteurs CX et CY. D'autres circuits logiques fournissent le signal de fin de comptage FIN en fonction des signaux A, C et des signaux de dépassement xn, yp, sq des compteurs CX, CY, CS. Les fonctions logiques réalisées par ces circuits peuvent être résumées par les équations logiques suivantes :

$$(1) \qquad INCX = INC.B^{*},$$

avec $B^{*}$ complément de B

$$(2) \qquad si\ B + C = 0,\ INCY = xn + D.yp$$

$$(3) \qquad si\ B + C = 1,\ INCY = INC + D.yp$$

$$(4) \qquad INCS = yp.(FE + D)$$

$$(5) \qquad si\ FE + D = 1,\ FIN = sq$$

$$(6) \qquad si\ A + C = 1,\ FIN = xn$$

$$(7) \qquad si\ A + C = 0,\ FIN = yp.$$

Le générateur 11 reçoit aussi des signaux d'horloges non représentés servant à synchroniser son fonctionnement, notamment celui des compteurs, avec le fonctionnement des autres unités avec lesquelles il échange des signaux.

Le fonctionnement du générateur d'adresse se déduit aisément du schéma et des formules. En fonctionnement normal, les signaux A, B, C, D sont tous à zéro. Si le signal de commande d'effacement global FE est inactif, le compteur CX est incrémenté par le signal INC et le compteur CY est incrémenté par le signal de dépassement xn du compteur CX. Le signal de dépassement yp du compteur CX fournit alors le signal FIN. Si le signal d'effacement global FE est actif, le compteur de secteur CS est incrémenté par le signal de dépassement yp et le signal de dépassement sq fournit le signal FIN.

Lorsque le premier mode de test A est actif, seul le compteur de rangée CX est incrémenté et son signal de dépassement xn fournit le signal de fin de comptage FIN. Selon le second mode de test, le signal B est actif, ce qui implique que seul le compteur de colonne CY est incrémenté et son signal de dépassement yp fournit le signal de fin de comptage FIN. Selon le troisième mode de test, C est actif et les compteurs CX et CY sont incrémentés simultanément. Comme on a supposé que n était supérieur à p, le signal de fin de comptage FIN est fourni par le signal de dépassement xn. Selon le quatrième mode de test, le signal D est actif et comme précédemment, les compteurs CX et CY sont incrémentés simultanément. Le dépassement yp du compteur CY provoque l'incrémentation du compteur de secteur CS ainsi qu'une incrémentation du compteur de colonne CY de façon à provoquer un décalage des diagonales lorsqu'on passe d'un secteur au suivant. Le signal de fin de comptage FIN est fourni par le signal de dépassement sq du compteur CS.

La figure 3 représente un exemple de réalisation du générateur de donnée 12 en liaison avec les circuits de lecture et d'écriture des cellules de la mémoire. Pour simplifier le schéma, seuls ont été représentés les circuits qui concernent un seul bit de données. Le cas d'une mémoire organisée en mots de plusieurs bits pourra se déduire aisément de ce schéma en prévoyant plusieurs circuits en parallèle associés respectivement aux différents bits formant chaque mot.

La figure représente une partie d'une matrice 1 utilisant comme cellules mémoire des transistors MOS à grilles flottantes. Une rangée est alors formée de plusieurs transistors ayant leurs sources reliées entre elles et alimentées par le circuit d'alimentation des sources 6 non représenté. De même, les grilles d'une rangée sont alimentées en parallèle par l'intermédiaire du circuit de sélection 5 au moyen du circuit d'alimentation des grilles 6 non représenté. Les transistors d'une même colonne ont leurs drains reliés entre eux par des lignes de bits $BL_0$, $BL_1$, ..., $BL_{p-1}$. Les lignes de bits sont reliées au moyen de lecture 16 et au circuit d'alimentation des drains 9 par l'intermédiaire des circuits de sélection des colonnes 7A, 7B commandés par les décodeurs de colonnes et de secteurs en fonction respectivement des adresses de colonne et de secteur. Le circuit d'alimentation 9 applique la tension de programmation des drains Vp en réponse au signal de commande de programmation D1 fourni par le sélecteur de donnée 8. Le sélecteur 8 est un multiplexeur à deux entrées reliées respectivement à la sortie Dp du générateur de donnée 12 et à la sortie Di d'une des bascules du registre de donnée d'entrée DTi-R. Le multiplexeur 8 est commandé par le signal de commande d'écriture WR issu du circuit de commande 3. La sortie des moyens d'amplification 16 est reliée à l'entrée Do d'une des bascules du registre de donnée de sortie DTo-R ainsi qu'à une entrée du comparateur 10 dont la seconde entrée est reliée à la sortie D1 du multiplexeur 8.

Le générateur de donnée 12 reçoit du circuit de test 15 le second mot de test T2, de l'unité 2 les commandes de programmation et d'effacement P, E et du générateur d'adresse 11 les bits de poids faibles x0, y0 des adresses internes de rangée et de colonne X, Y. A titre d'exemple, le mot de test T2 est seulement formé de deux bits Td, Md prévus pour commander la formation de damiers. Plus précisément, le circuit décrit réalise la fonction logique suivante :

$$Dp = E + Md.P^{*} + Md.Dd$$

avec $P^{*}$ complément de P et

$$Dd = x0 \oplus y0 \oplus Td$$

Le circuit de la figure 3 fonctionne de la façon suivante. En réponse à une commande de lecture, les moyens d'amplification 16 sont activés et la bascule du registre DTo-R est chargée par son signal de sortie. En réponse à une commande externe d'écriture du mot chargé dans le registre DTi-R, le multiplexeur 8 est positionné de façon à commander le circuit d'alimentation 9 par le signal de sortie de la bascule correspondante de ce registre. Pour les autres opérations (algorithme de programmation avant effacement, algorithme d'effacement et tests), le multiplexeur 8 est positionné pour commander le circuit 9 par le signal de sortie Dp du générateur de donnée. Ainsi, conformément à l'équation logique précédente, on peut avoir les cas suivants. Lors d'un effacement ou d'une programmation avant effacement, les bits de test Td et Md sont à zéro. Il en résulte que Dp prend la valeur 1 lors de l'effacement (E = 1) et prend la valeur 0 lors de la programmation avant effacement (P = 1 et E = 0). Les modes de test sont activés comme pour une programmation avant effacement (P = 1, E = 0) en forçant Md à 1. Selon un premier mode de test (Td = 0), Dd prend la valeur 1 lorsque les adresses X et Y ont des parités différentes. Selon un second mode de test (Td = 1), Dd prend la valeur 1 lorsque X et Y ont la même parité. Dans les deux cas, on a Dp = Dd.

Ainsi, la programmation de damiers sera réalisée en donnant au second mot de test T2 les valeurs indiquées ci-dessus et en déclenchant l'algorithme de programmation avant effacement, le générateur d'adresse étant maintenant dans un de ses modes de fonctionnement normal.

De la description qui précède, on peut se rendre compte que la mise en oeuvre des tests nécessite très peu de modifications et de circuits additionnels par rapport à une mémoire classique. En particulier, aucun changement n'est à apporter aux algorithmes programmés dans l'unité 2.

Bien entendu, l'invention n'est pas limitée aux modes de réalisation particuliers qui viennent d'être décrits. L'homme du métier pourra concevoir aisément de nombreuses variantes de réalisation des générateurs d'adresse et de donnée pour obtenir d'autres configurations. Il suffira pour cela de faire dépendre les signaux d'incrémentation des compteurs et la valeur Dp de signaux de test supplémentaires ainsi que des valeurs de l'adresse interne X, Y, S selon des fonctions quelconques.

## Revendications

1. Mémoire non volatile modifiable électriquement par des opérations d'effacement et de programmation, ladite mémoire comportant :

   - au moins une matrice de cellules mémoire (1) organisées en rangées et en colonnes,

   - des moyens d'alimentation (6, 9, 14) pour appliquer des tensions d'effacement et de programmation (Vp) auxdites rangées et colonnes, lesdites tensions de programmation étant appliquées sélectivement aux rangées et colonnes identifiées respectivement par des adresses de rangée (X1) et des adresses de colonne (Y1),

   - un générateur d'adresse (11) comportant des moyens de comptage (CX, CY, CS) commandés par un signal d'incrémentation (INC),

   - des moyens de commande (2, 3, 8, 12) desdits moyens d'alimentation (6, 9, 14) et dudit générateur d'adresse (11),

ladite opération d'effacement consistant en l'exécution par lesdits moyens de commande (2, 3, 8, 12) d'un premier algorithme de programmation avant effacement suivi d'un second algorithme d'effacement, ledit premier algorithme consistant à commander l'incrémentation (INC) desdits moyens de comptage (CX, CY, CS) pour qu'il fournisse successivement toutes les valeurs possibles (X, Y) desdites adresses de rangée (X1) et de colonne (Y1) et, pour chaque valeur d'adresse fournie, à commander lesdits moyens d'alimentation (6, 9, 14) pour qu'ils fournissent lesdites tensions de programmation (Vp), ladite mémoire étant caractérisée en ce que lesdits moyens de comptage (CX, CY, CS) comportent un compteur de rangée (CX) et un compteur de colonne (CY) fournissant respectivement lesdites valeurs d'adresse de rangée (X) et de colonne (Y), en ce que ledit générateur d'adresse (11) est prévu pour fonctionner selon un mode normal et au moins un mode de test, le fonctionnement en mode(s) de test étant conditionné par un premier mot de test (T1), ledit mode normal consistant à incrémenter ledit compteur de rangée (CX) exclusivement par ledit signal d'incrémentation (INC) et ledit compteur de colonne (CY) exclusivement par un signal de dépassement (xn) dudit compteur de rangée (CX), le(s)dit(s) mode(s) de test consistant à autoriser l'incrémentation par ledit signal d'incrémentation (INC) dudit compteur de rangée (CX) et/ou l'incrémentation dudit compteur de colonne (CY) en fonction dudit premier mot de test (T1).

2. Mémoire selon la revendication 1, caractérisée en ce qu'un premier mode de test (A) consiste à incrémenter exclusivement ledit compteur de rangée (CX) par ledit signal d'incrémentation (INC).

3. Mémoire selon l'une des revendications 1 ou 2, caractérisée en ce qu'un second mode de test (B) consiste à incrémenter exclusivement ledit compteur de colonne (CY) par ledit signal d'incrémentation (INC).

**4.** Mémoire selon l'une des revendications 1 à 3, caractérisée en qu'un troisième mode de test (C) consiste à incrémenter simultanément lesdits compteurs de rangée et de colonne (CX, CY) par ledit signal d'incrémentation (INC).

**5.** Mémoire selon l'une des revendications 1 à 4 comportant plusieurs matrices de cellules mémoire (1) définissant chacune un secteur sélectionnable par une adresse de secteur (S1), caractérisée en ce que lesdits moyens de comptage (CX, CY, CS) comportent un compteur de secteur (CS) et en ce qu'un quatrième mode de test (D) consiste à incrémenter simultanément lesdits compteurs de rangée et de colonne (CX, CY) par ledit signal d'incrémentation (INC) et à commander l'incrémentation dudit compteur de secteur (CS) par un signal de dépassement (yp) dudit compteur de colonne (CY).

**6.** Mémoire selon la revendication 5, caractérisée en ce que ledit signal de dépassement (yp) dudit compteur de colonne (CY) commande l'incrémentation dudit compteur de colonne (CY) lorsque le générateur d'adresse (11) fonctionne selon ledit quatrième mode de test (D).

**7.** Mémoire selon l'une des revendications 1 à 6, caractérisée en ce que lesdits moyens de commande (2, 3, 9, 12) comportent au moins un générateur de donnée (12) pouvant être placé dans un premier ou un second état et qui, lors de l'exécution dudit premier algorithme, commande lesdits moyens d'alimentation (6, 9, 14) pour qu'ils appliquent lesdites tensions de programmation (Vp) à condition que ledit générateur de donnée (12) soit dans ledit premier état, en ce que ledit générateur de donnée (12) est prévu pour fonctionner selon un mode normal ou au moins un mode de test, le fonctionnement en mode de test étant conditionné par un second mot de test (T2), ledit fonctionnement en mode normal consistant à placer ledit générateur de donnée (12) dans ledit premier état, le fonctionnement en mode de test consistant à placer ledit générateur de donnée (12) dans ledit second état en fonction dudit second mot de test (T2) et des adresses fournies par ledit générateur d'adresse (11).

**8.** Mémoire selon la revendication 7, caractérisée en ce qu'un cinquième mode de test consiste à faire fonctionner ledit générateur d'adresse (11) selon son mode normal et à forcer ledit générateur de donnée (12) dans ledit premier état lorsque les valeurs contenues dans lesdits compteurs de rangée et de colonne (CX, CY) ont la même parité.

**9.** Mémoire selon l'une des revendications 7 ou 8, caractérisée en ce qu'un sixième mode de test consiste à faire fonctionner ledit générateur d'adresse (11) selon son mode normal et à forcer ledit générateur de donnée (12) dans ledit premier état lorsque les valeurs contenues dans lesdits compteurs de rangée et de colonne (CX, CY) ont des parités opposées.

**10.** Circuit intégré caractérisé en ce qu'il contient une mémoire selon l'une des revendications 1 à 9 ainsi qu'un circuit de test (15) prévu pour fournir des mots de test (T1, T2) en réponse à des commandes de test extérieures audit circuit intégré.

**Patentansprüche**

**1.** Nichtflüchtiger Speicher, der durch Lösch- und Programmierungsoperationen elektrisch modifizierbar ist und enthält:

- wenigstens eine Matrix von Speicherzellen (1), die in Zeilen und Spalten organisiert sind,

- Versorgungsmittel (6, 9, 14), die an die Zeilen und Spalten Lösch- und Programmierungsspannungen (Vp) anlegen, wobei die Programmierungsspannungen wahlweise an diejenigen Zeilen und Spalten angelegt werden, die durch Zeilenadressen (X1) bzw. durch Spaltenadressen (Y1) gekennzeichnet werden,

- einen Adressengenerator (11), der Zählmittel (CX, CY, CS) enthält, die durch ein Inkrementierungssignal (INC) gesteuert werden,

- Steuermittel (2, 3, 8, 12) für die Versorgungsmittel (6, 9, 14) und den Adressengenerator (11),

- wobei die Löschoperation darin besteht, durch die Steuermittel (2, 3, 8, 12) vor dem Löschen einen ersten Programmierungsalgorithmus auszuführen, gefolgt von einem zweiten Löschalgorithmus, wobei der erste Algorithmus darin besteht, die Inkrementierung (INC) der Zählmittel (CX, CY, CS) so zu steuern, daß er nacheinander sämtliche möglichen Werte (X, Y) der Zeilenadressen (X1) und der Spaltenadressen (Y1) liefert, und für jeden gelieferten Adressenwert die Versorgungsmittel (6, 9, 14) so zu steuern, daß sie die Programmierungsspannungen (Vb) liefern, wobei der Speicher dadurch gekennzeichnet ist, daß die Zählmittel (CX, CY, CS) einen Zeilenzähler (CX) und einen Spaltenzähler (CY) enthalten, die die Zeilen-Adressenwerte (X) bzw. die Spalten-Adressenwerte (Y) liefern, daß der Adressengenerator (11) so beschaffen ist, daß er in einer normalen Betriebsart und wenigstens einer Prüfbetriebsart arbeitet, wobei die Funktion in der (den) Prüfart(en) durch ein erstes Prüfwort (T1) bedingt ist, wobei die normale Betriebsart darin besteht, den Zeilenzähler (CX) ausschließlich durch das Inkrementierungssignal (INC) und den Spaltenzähler (CY) ausschließlich durch das Überlaufsignal (xn) des Zeilenzählers (CX) zu inkrementieren, wobei die Prüfbetriebsart (en) darin besteht (bestehen), die Inkrementierung durch das Inkrementierungssignal (INC) des Zeilenzählers (CX) und/oder die Inkrementierung des Spaltenzählers (CY) in Abhängigkeit vom ersten Prüfwort (T1) zuzulassen.

2. Speicher nach Anspruch 1, dadurch gekennzeichnet, daß eine erste Prüfbetriebsart (A) darin besteht, ausschließlich den Zeilenzähler (CX) durch das Inkrementierungssignal (INC) zu inkrementieren.

3. Speicher nach einem der Ansprüche 1 oder 2, dadurch gekennzeichnet, daß eine zweite Prüfbetriebsart (B) darin besteht, ausschließlich den Spaltenzähler (CY) durch das Inkrementierungssignal (INC) zu inkrementieren.

4. Speicher nach einem der Ansprüche 1 bis 3, dadurch gekennzeichnet, daß eine dritte Prüfbetriebsart (C) darin besteht, zugleich die Zeilen- und Spaltenzähler (CX, CY) durch das Inkrementierungssignal (INC) zu inkrementieren.

5. Speicher nach einem der Ansprüche 1 bis 4, der mehrere Matrizen von Speicherzellen (1) enthält, die jeweils einen durch eine Sektoradresse (S1) wählbaren Sektor definieren, dadurch gekennzeichnet, daß die Zählmittel (CX, CY, CS) einen Sektorzähler (CS) enthalten und daß eine vierte Prüfbetriebsart (D) darin besteht, zugleich die Zeilen- und Spaltenzähler (CX, CY) durch das Inkrementierungssignal (INC) zu inkrementieren und die Inkrementierung des Sektorzählers (CS) durch ein Überlaufsignal (yp) des Spaltenzählers (CY) zu steuern.

6. Speicher nach Anspruch 5, dadurch gekennzeichnet, daß das Überlaufsignal (yp) des Spaltenzählers (CY) die Inkrementierung des Spaltenzählers (CY) steuert, wenn der Adressengenerator (11) in der vierten Prüfbetriebsart (D) arbeitet.

7. Speicher nach einem der Ansprüche 1 bis 6, dadurch gekennzeichnet, daß die Steuermittel (2, 3, 9, 12) wenigstens einen Datengenerator (12) enthalten, der in einen ersten oder in einen zweiten Zustand versetzt werden kann und der bei der Ausführung des ersten Algorithmus die Versorgungsmittel (6, 9, 14) steuert, damit sie unter der Voraussetzung, daß der Datengenerator (12) sich im ersten Zustand befindet, die Programmierspannungen (Vp) anlegen, daß der Datengenerator (12) so beschaffen ist, daß er in einer normalen Betriebsart oder in wenigstens einer Prüfbetriebsart arbeitet, wobei die Funktion in der Prüfbetriebsart durch ein zweites Prüfwort (T2) bedingt ist, wobei die Funktion in der normalen Betriebsart darin besteht, den Datengenerator (12) in den ersten Zustand zu versetzen, und wobei die Funktion in der Prüfbetriebsart darin besteht, den Datengenerator (12) in Abhängigkeit vom zweiten Prüfwort (T2) und von den vom Adressengenerator (11) gelieferten Adressen in den zweiten Zustand zu versetzen.

8. Speicher nach Anspruch 7, dadurch gekennzeichnet, daß eine fünfte Prüfbetriebsart darin besteht, den Adressengenerator (11) in seiner normalen Betriebsart arbeiten zu lassen und den Datengenerator (12) in den ersten Zustand zu versetzen, wenn die in den Zeilen- und Spaltenzählern (CX, CY) enthaltenen Werte die gleiche Parität besitzen.

9. Speicher nach einem der Ansprüche 7 oder 8, dadurch gekennzeichnet, daß eine sechste Prüfbetriebsart darin besteht, den Adressengenerator (11) in seiner normalen Betriebsart arbeiten zu lassen und den Datengenerator (12) in den ersten Zustand zu versetzen, wenn die in den Zeilen- und Spaltenzählern (CX, CY) enthaltenen Werte entgegengesetzte Paritäten besitzen.

10. Integrierte Schaltung, dadurch gekennzeichnet, daß sie einen Speicher nach einem der Ansprüche 1 bis 9 sowie eine Prüfschaltung (15) enthält, die dazu vorgesehen ist, die Prüfwörter (T1, T2) als Antwort auf Prüfbefehle von außerhalb der integrierten Schaltung zu liefern.

**Claims**

1. Non-volatile memory modifiable electrically by erasure and programming operations, the said memory having :

   - at least one matrix of memory cells (1) organised in rows and columns,

   - power supply means (6, 9, 14) for applying voltages for erasure and programming (Vp) to the said rows and columns, the said programming voltages being applied selectively to the rows and columns identified respectively by row addresses (X1) and column addresses (Y1),

   - an address generator (11) having counting means (CX, CY, CS) controlled by an increment signal (INC),

- means (2, 3, 8, 12) for controlling the said power supply means (6, 9, 14) and the said address generator (11),

the said erasure operation consisting of the execution by the said control means (2, 3, 8, 12) of a first pre-erasure programming algorithm followed by a second erasure algorithm, the said first algorithm consisting of controlling the incrementation (INC) of the said counting means (CX, CY, CS) so that it successively provides all possible values (X, Y) of the said row (X1) and column (Y1) addresses and, for each address value supplied, controlling the said power supply means (6, 9, 14) so that they provide the said programming voltages (Vp), the said memory being characterised in that the said counting means (CX, CY, CS) have a row counter (CX) and a column counter (CY) supplying respectively the said row (X) and column (Y) address values, in that the said address generator (11) is designed to operate according to a normal mode and at least one test mode, the operation in test mode(s) being conditioned by a first test word (T1), the said normal mode consisting in incrementing the said row counter (CX) only by the said increment signal (INC) and the said column counter (CY) only by an overflow signal (xn) from the said row counter (CX), the said test mode(s) consisting of allowing incrementing by the said increment signal (INC) of the said row counter (CX) and/or incrementing of the said column counter (CY) according to the said first test word (T1).

2. Memory according to Claim 1, characterised in that a first test mode (A) consists of incrementing only the said row counter (CX) by the said increment signal (INC).

3. Memory according to one of Claims 1 or 2, characterised in that a second test mode (B) consists of incrementing only the said column counter (CY) by the said increment signal (INC).

4. Memory according to one of Claims 1 to 3, characterised in that a third test mode (C) consists of simultaneously incrementing the said row and column counters (CX, CY) by the said increment signal (INC).

5. Memory according to one of Claims 1 to 4 having several matrices of memory cells (1) each defining a sector selectable by a sector address (S1) , characterised in that the said counting means (CX, CY, CS) have a sector counter (CS) and in that a fourth test mode (D) consists of simultaneously incrementing the said row and column counters (CX, CY) by the said increment signal (INC) and controlling the incrementing of the said sector counter (CS) by an overflow signal (yp) from the said column counter (CY).

6. Memory according to Claim 5, characterised in that the said overflow signal (yp) from the said column counter (CY) controls the incrementing of the said column counter (CY) when the address generator (11) operates according to the said fourth test mode (D).

7. Memory according to one of Claims 1 to 6, characterised in that the said control means (2, 3, 9, 12) have at least one data generator (12) capable of being placed in a first or a second state and which, on execution of the said first algorithm, controls the said power supply means (6, 9, 14) so that they apply the said programming voltages (Vp) provided that the said data generator (12) is in the said first state, in that the said data generator (12) is designed to operate according to a normal mode or at least one test mode, the operation in test mode being conditioned by a second test word (T2), the said operation in normal mode consisting of placing the said data generator (12) in the said first state, the operation in test mode consisting of placing the said data generator (12) in the said second state according to the said second test word (T2) and the addresses supplied by the said address generator (11).

8. Memory according to Claim 7, characterised in that a fifth test mode consists of operating the said address generator (11) according to its normal mode and forcing the said data generator (12) into the said first state when the values contained in the said row and column counters (CX, CY) have the same parity.

9. Memory according to one of Claims 7 or 8, characterised in that a sixth test mode consists of operating the said address generator (11) according to its normal mode and forcing the said data generator (12) into the said first state when the values contained in the said row and column counters (CX, CY) have opposite parities.

10. Integrated circuit characterised in that it contains a memory according to one of Claims 1 to 9 and a test circuit (15) designed to supply test words (T1, T2) in response to test commands external to the said integrated circuit.

FIG. 1

EP 0 676 769 B1

FIG. 2

FIG. 3

EP 0 676 769 B1

13